# EUROPEAN PATENT APPLICATION

(11) **EP 4 811 073 A1**
(43) Date of publication of application: **23.09.2026**
(21) Application number: 24915519.3
(22) Date of filing: 18.11.2024
(51) Int. Cl.: G06F 1/16, H05K 1/14, H05K 1/18, H04M 1/02

(54) **DISPLAY ASSEMBLY AND ELECTRONIC DEVICE COMPRISING SAME**

(30) Priority: 05.01.2024 KR 20240002537; 29.01.2024 KR 20240013073
(71) Applicant: Samsung Electronics Co., Ltd., Suwon-si, Gyeonggi-do 16677 (KR)
(72) Inventor: KIM, Dongwoo, Suwon-si Gyeonggi-do 16677 (KR); KIM, Byeongsoo, Suwon-si Gyeonggi-do 16677 (KR); LEE, Injoo, Suwon-si Gyeonggi-do 16677 (KR); JEONG, Heejae, Suwon-si Gyeonggi-do 16677 (KR); BAE, Jaehyun, Suwon-si Gyeonggi-do 16677 (KR)
(74) Representative: HGF
(86) International application number: PCT/KR2024/018187
(87) International publication number: WO 2025/146936

(57) **Abstract**

A display assembly according to one embodiment of the present invention may comprise : a display panel ; a polymer layer disposed on the rear surface of the display panel; a flexible circuit board electrically connected to the display panel and disposed outside the edge of the display panel; a display driving chip mounted on the flexible circuit board; and a resin layer configured to surround the flexible circuit board. At least a portion of the edge of the polymer layer may include a flat or curved first inclined surface that forms a substantially obtuse angle with respect to the rear surface of the display panel.

## Description

### [Technical Field]

Various embodiments of the disclosure relate to a display assembly and an electronic device including the same.

### [Background Art]

As information and communication technology and semiconductor technology develop, the distribution and use of various electronic devices are increasing rapidly. In particular, recent electronic devices are being developed to be portable, mobile, and capable of communicating.

The electronic device may refer to a device that performs a specific function according to a mounted program, such as home appliances, electronic organizers, portable multimedia players, mobile communication terminals, tablet personal computers, audio and visual devices, desktop and laptop computers, and vehicle navigation systems. For example, such electronic devices may output stored information as sound or images. As the integration degree of electronic devices increases and high-speed, large-capacity wireless communication becomes common, recently, various functions may be mounted on a single electronic device such as a mobile communication terminal. For example, communication functions as well as entertainment functions such as games, multimedia functions such as music and video playback, communication and security functions for mobile banking, and functions such as schedule management and electronic wallet are being integrated into a single electronic device. Such an electronic device is being reduced in size so that a user can conveniently carry it.

The foregoing may be provided as background technology (related art) for the purpose of facilitating understanding of the disclosure. It is not asserted or decided whether any of the aforementioned matters can be applied as prior art related to the disclosure.

### [Disclosure of Invention]

### [Solution to Problems]

A display assembly according to an embodiment of the disclosure may include a display panel, a polymer layer disposed on a rear surface of the display panel, a flexible circuit board electrically connected to the display panel and disposed outside an edge of the display panel, a display driving chip mounted on the flexible circuit board, and a resin layer configured to surround the flexible circuit board. The polymer layer may include a first inclined surface of a planar or curved shape, at least a portion of an edge of which forms a substantially obtuse angle with respect to the rear surface of the display panel.

An electronic device according to an embodiment of the disclosure may include a housing and a display assembly disposed on the housing. The display assembly may include a display panel, a polymer layer disposed on a rear surface of the display panel, a flexible circuit board electrically connected to the display panel and disposed outside an edge of the display panel, a display driving chip mounted on the flexible circuit board, and a resin layer configured to surround the flexible circuit board. The polymer layer may include a first inclined surface of a planar or curved shape, at least a portion of an edge of which forms a substantially obtuse angle with respect to the rear surface of the display panel.

Effects achievable in example embodiments of the disclosure are not limited to the effects mentioned above, and other effects not mentioned can be clearly derived and understood by one of ordinary skill in the art to which example embodiments of the disclosure belong from the following description. That is, unintended effects according to the implementation of example embodiments of the disclosure may also be derived by one of ordinary skill in the art from example embodiments of the disclosure.

### [Brief Description of Drawings]

FIG. 1 is a block diagram of an electronic device in a network environment according to various embodiments.
FIG. 2 is a perspective view illustrating a front surface of an electronic device according to an embodiment.
FIG. 3 is a perspective view illustrating a rear surface of the electronic device illustrated in FIG. 2 according to an embodiment.
FIG. 4a is an exploded perspective view of the electronic device illustrated in FIG. 2, illustrating a front surface according to an embodiment.
FIG. 4b is an exploded perspective view of the electronic device illustrated in FIG. 2, illustrating a rear surface according to an embodiment.
FIG. 5 is a rear view of the display assembly according to an embodiment.
FIG. 6a is an enlarged view of a portion of FIG. 5 according to an embodiment, illustrating a state in which the resin layer is omitted.
FIG. 6b is an enlarged view of a portion of FIG. 5 according to an embodiment.
FIG. 7 is a cross-sectional view cut along the line A-A of FIG. 6a according to an embodiment.
FIG. 8 is an exploded perspective view of a jig device prepared for filling a resin layer in the display assembly according to an embodiment.
FIG. 9 is a schematic view illustrating a coupling relationship between the display assembly and a mold cap according to an embodiment.
FIG. 10 is a schematic view illustrating a process of filling a molding liquid using the jig device of FIG. 8 according to an embodiment.
FIG. 11 is a schematic view illustrating two types of resin layers having different hardness according to an embodiment.
FIG. 12 is a partial perspective view of the display assembly according to an embodiment, illustrating a state in which the resin layer is omitted.
FIG. 13 is a partial perspective view of the display assembly according to an embodiment.
FIG. 14 is an enlarged rear view of a portion of the display assembly according to an embodiment.

In the following description, the attached drawings are referred to, and specific examples that may be implemented are illustrated as examples in the drawings. Additionally, other examples may be utilized and structural changes may be made without departing from the scope of the various examples.

### [Mode for the Invention]

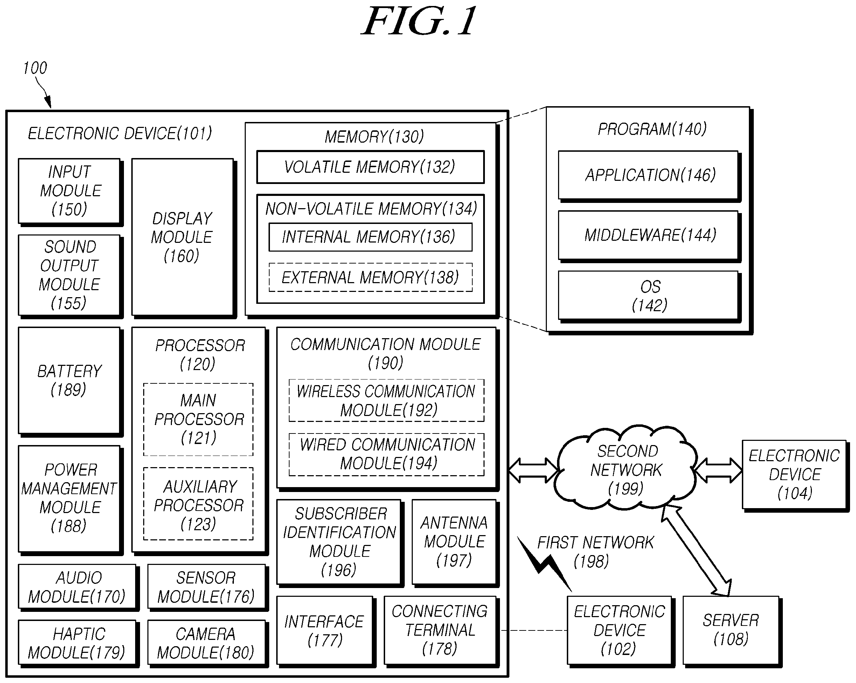

FIGS. 1 to 14 disclosed below and various embodiments used to explain the principles of the disclosure in this patent document are only for illustrative purposes and should not be construed as limiting the scope of the disclosure in any way. One of ordinary skill in the art will understand that the principles of the disclosure may be implemented in any system or apparatus with appropriately arranged components.

Hereinafter, embodiments of the disclosure are described in detail with reference to the drawings so that one of ordinary skill in the art to which the disclosure pertains may easily practice the disclosure. However, the disclosure may be implemented in various different forms and is not limited to the embodiments described herein. In the description of the drawings, the same or similar reference denotations may be used for the same or similar components. Additionally, in the drawings and related description, descriptions of well-known functions and constructions may be omitted for clarity and conciseness.

FIG. 1 is a block diagram of an electronic device 101 in a network environment 100 according to an embodiment of the disclosure.

Referring to FIG. 1, an electronic device 101 in a network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the strength of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) (e.g., a speaker or a headphone) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197. According to various embodiments, the antenna module 197 may form an mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

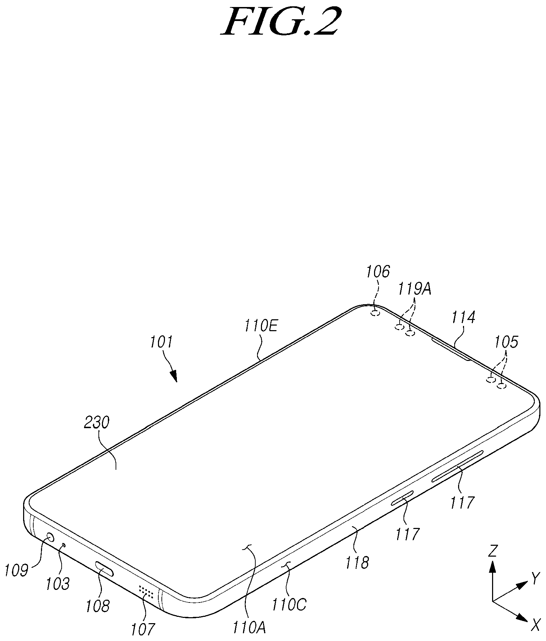

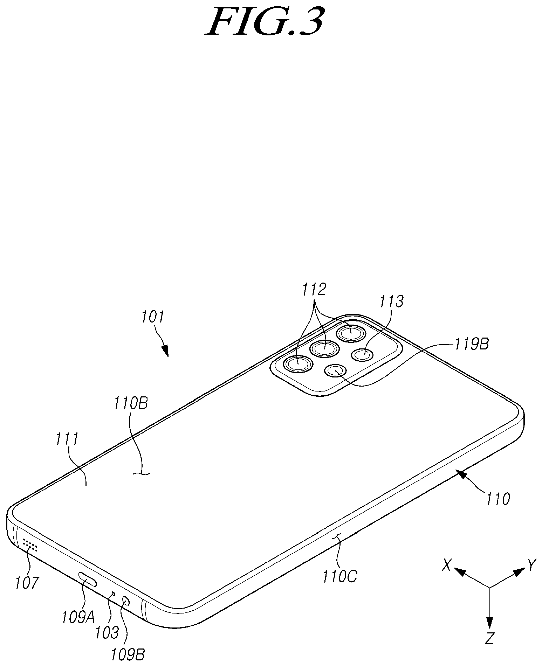

FIG. 2 is a perspective view illustrating a front surface of an electronic device according to an embodiment disclosed in this document. FIG. 3 is a perspective view illustrating a rear surface of the electronic device illustrated in FIG. 2 according to an embodiment disclosed in this document.

All features, components, and/or arrangements of components shown in FIGS. 2 and 3 may be included, alone or in combination, with features, components, and arrangements of components described in other drawings of this specification. Similarly, all features, components, and/or arrangements of components described with respect to FIG. 1 and FIGS. 4a to 14 may be included, alone or in combination, with features, components, and arrangements of components described in FIGS. 2 and 3.

Referring to FIGS. 2 and 3, an electronic device 101 (e.g., the electronic device 101 of FIG. 1) according to an embodiment may include a housing 110 including a first surface (or front surface) 110A, a second surface (or rear surface) 110B, and a side surface 110C surrounding a space between the first surface 110A and the second surface 110B. In an embodiment (not illustrated), the housing 110 may refer to a structure forming the first surface 110A of FIG. 2, the second surface 110B of FIG. 3, and some of the side surfaces 110C.

According to an embodiment, the first surface 110A may be formed by a front plate 110E that is substantially transparent in at least a portion thereof (e.g., a glass plate or a polymer plate including various coating layers). The second surface 110B may be formed by a rear plate 111 that is substantially opaque. The rear plate 111 may be formed by, for example, coated or colored glass, ceramic, polymer, metal (e.g., aluminum, stainless steel (STS), or magnesium), or a combination of at least two of the aforementioned materials. The side surface 110C is coupled with the front plate 110E and the rear plate 111 and may be formed by a side structure (or "side bezel structure") 118 including metal and/or polymer. In an embodiment, the rear plate 111 and the side structure 118 may be integrally formed and include the same material (e.g., a metallic material such as aluminum).

According to an embodiment, the front plate 110E may include area(s) that are curved and seamlessly extend toward the rear plate 111 at least at a portion of the edge. For example, the front plate 110E (or the rear plate 111) may include only one of the areas curved and extended toward the rear plate 111 (or the front plate 110E) at one edge of the first surface 110A. According to an embodiment, the front plate 110E or the rear plate 111 may be substantially planar in shape, in which case, it may not include a curved and extended area. When the front plate 110E or the rear plate 111 includes a curved and extended area, the thickness of the electronic device 101 at the portion where the curved and extended area is included may be smaller than the thickness of the other portion.

According to an embodiment, the electronic device 101 may include at least one of a display 230, an audio module (e.g., a microphone hole 103, an external speaker hole 107, a call receiver hole 114), a sensor module (e.g., a first sensor module 119A, a second sensor module (not illustrated), a third sensor module 119B), a camera module (e.g., a first camera device 105, a second camera device 112, a flash 113), a key input device 117, a light emitting element 106, and a connector hole (e.g., a first connector hole 109A, a second connector hole 109B). In an embodiment, the electronic device 101 may omit at least one of the components (e.g., the key input device 117 or the light emitting element 106) or may further include another component.

The display 230 may output a screen or be visually exposed through a substantial portion of the first surface 110A (e.g., the front plate 110E). In an embodiment, at least a portion of the display 230 may be visually exposed through the front plate 110E that forms the first surface 110A or through a portion of the side surface 110C. In an embodiment, the edge of the display 230 may be formed to be substantially identical to the adjacent outer shape of the front plate 110E. In an embodiment (not illustrated), in order to expand the display area through which the display 230 is visually exposed, the spacing between the outer edge of the display 230 and the outer edge of the front plate 110E may be formed to be substantially identical.

According to an embodiment, a recess or an opening may be formed in a portion of the screen display area of the display 230, and the device may include at least one of an audio module (e.g., a call receiver hole 114), a sensor module (e.g., a first sensor module 119A), a camera module (e.g., a first camera device 105), and a light emitting element 106 aligned with the recess or the opening. In an embodiment (not illustrated), on the rear surface of the screen display area of the display 230, the device may include at least one of an audio module (e.g., a call receiver hole 114), a sensor module (e.g., a first sensor module 119A), a camera module (e.g., a first camera device 105), a fingerprint sensor (not illustrated), and a light emitting element 106. In an embodiment (not illustrated), the display 230 may be combined with or disposed adjacent to a touch sensing circuit, a pressure sensor capable of measuring the intensity (pressure) of a touch, and/or a digitizer that detects a magnetic-field-type stylus pen.

According to an embodiment, the audio module 103, 107, 114 may include a microphone hole 103 and speaker holes (e.g., an external speaker hole 107 and a call receiver hole 114). The microphone hole 103 may have a microphone disposed therein for acquiring external sound, and in an embodiment, a plurality of microphones may be disposed to sense the direction of sound. The speaker hole may include an external speaker hole 107 and a call receiver hole 114. In an embodiment, a speaker hole (e.g., an external speaker hole 107 or a call receiver hole 114) and the microphone hole 103 may be implemented as a single hole, or a speaker (e.g., a piezo speaker) may be included without a speaker hole (e.g., an external speaker hole 107 and a call receiver hole 114).

According to an embodiment, the sensor module may generate electrical signals or data values corresponding to an internal operating state of the electronic device 101 or an external environmental state. The sensor module may include, for example, a first sensor module 119A (e.g., a proximity sensor) and/or a second sensor module (not illustrated) (e.g., a fingerprint sensor) disposed on the first surface 110A of the housing 110, and/or a third sensor module 119B disposed on the second surface 110B of the housing 110. A second sensor module (not illustrated) (e.g., a fingerprint sensor) may be disposed on the first surface 110A (e.g., the display 230) of the housing 110, as well as on the second surface 110B or the side surface 110C. The electronic device 101 may further include at least one of, for example, a gesture sensor, a gyro sensor, a barometric pressure sensor, a magnetic sensor, an acceleration sensor, a grip sensor, a color sensor, an IR (infrared) sensor, a biometric sensor, a temperature sensor, a humidity sensor, or an illuminance sensor 104.

According to an embodiment, the camera module may include a first camera device 105 disposed on the first surface 110A of the electronic device 101, a second camera device 112 disposed on the second surface 110B, and/or a flash 113. The camera devices (e.g., the first camera device 105 and the second camera device 112) may include one or a plurality of lenses, an image sensor, and/or an image signal processor. The flash 113 may include, for example, a light emitting diode or a xenon lamp. In an embodiment, one or more lenses (an infrared camera, a wide-angle and telephoto lens) and image sensors may be disposed on one surface of the electronic device 101. In an embodiment, the flash 113 may emit infrared light, and infrared light emitted by the flash 113 and reflected by a subject may be received through the third sensor module 119B. The electronic device 101 or a processor of the electronic device 101 (e.g., the processor 120 in FIG. 1) may detect depth information of a subject based on a time point at which infrared light is received in the third sensor module 119B.

According to an embodiment, the key input device 117 may be disposed on the side surface 110C of the housing 110. In an embodiment, the electronic device 101 may not include some or all of the aforementioned key input device 117, and the key input device 117 that is not included may be implemented in another form, such as a soft key, on the display 230. In an embodiment, the key input device may include a sensor module disposed on the second surface 110B of the housing 110.

According to an embodiment, the light emitting element 106 may be disposed on the first surface 110A of the housing 110, for example. The light emitting element 106 may provide state information of the electronic device 101 in the form of light, for example. In an embodiment, the light emitting element 106 may provide, for example, a light source that operates in conjunction with the camera module (e.g., the first camera device 105). The light emitting element 106 may include, for example, an LED, an IR LED, and a xenon lamp.

According to an embodiment, the connector hole (e.g., the first connector hole 109A and the second connector hole 109B) may include a first connector hole 109A capable of accommodating a connector (e.g., a USB connector) for transmitting and receiving power and/or data to and from an external electronic device (e.g., the electronic device 102 in FIG. 1), and/or a second connector hole 109 (e.g., an earphone jack) capable of accommodating a connector for transmitting and receiving audio signals to and from an external electronic device.

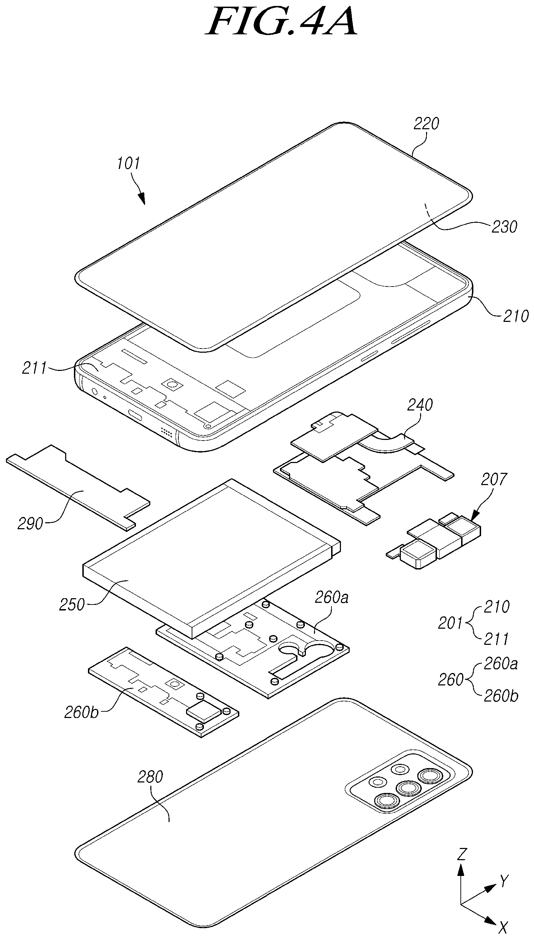

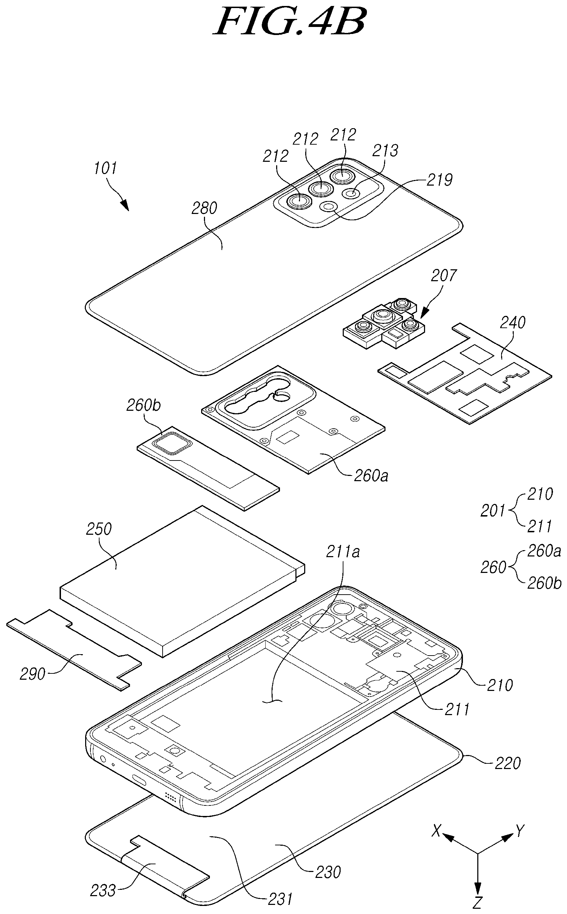

FIG. 4A is a view illustrating a front of an exploded perspective view of the electronic device shown in FIG. 2 according to an embodiment disclosed in the present document. FIG. 4B is a view illustrating a rear of an exploded perspective view of the electronic device shown in FIG. 2 according to an embodiment disclosed in the present document.

All features, components, and/or arrangement relationships between components shown in FIGS. 4A and 4B may be included, individually or in combination, in the features, components, and arrangement relationships between components described in other drawings of the present specification. Similarly, all features, components, and/or arrangement relationships between components described in connection with FIGS. 1 to 3 and FIGS. 5 to 14 may be included, individually or in combination, in the features, components, and arrangement relationships between components described in FIGS. 4A and 4B.

Referring to FIGS. 4A and 4B, the electronic device 101 (e.g., the electronic device 101 in FIG. 1, FIG. 2, or FIG. 3) may include a side structure 210, a first support member 211 (e.g., a bracket), a front plate 220 (e.g., the front plate 110E in FIG. 2), a display 230 (e.g., the display 230 in FIGS. 2 and 3), a printed circuit board (or a board assembly) 240, a battery 250, a second support member 260 (e.g., a rear case), an antenna, a camera assembly 207, and a rear plate 280 (e.g., the rear plate 111 in FIG. 3).

According to an embodiment, the electronic device 101 may omit at least one of the components (e.g., the first support member 211 or the second support member 260) or may further include another component. At least one of the components of the electronic device 101 may be the same or similar to at least one of the components of the electronic device 101 in FIG. 2 or FIG. 3, and redundant descriptions are omitted hereinafter.

According to an embodiment, the first support member 211 may be disposed inside the electronic device 101 and connected to the side structure 210, or may be integrally formed with the side structure 210. The first support member 211 may be formed of, for example, a metal material and/or a non-metal (e.g., polymer) material. When at least partially formed of a metal material, a portion of the side structure 210 or the first support member 211 may function as an antenna. The first support member 211 may have the display 230 coupled to one side and the printed circuit board 240 coupled to the other side. The printed circuit board 240 may be mounted with a processor (e.g., the processor 120 in FIG. 1), a memory (e.g., the memory 130 in FIG. 1), and/or an interface (e.g., the interface 177 in FIG. 1). The processor may include, for example, one or more of a central processing unit, an application processor, a graphics processing unit, an image signal processor, a sensor hub processor, or a communication processor.

According to an embodiment, the first support member 211 and the side structure 210 may be combined to be referred to as a front case or a housing 201. According to an embodiment, the housing 201 may generally be understood as a structure for accommodating, protecting, or disposing the printed circuit board 240 or the battery 250. In an embodiment, the housing 201 may be understood to include a structure that a user can visually or tactilely perceive from the external appearance of the electronic device 101, for example, the side structure 210, the front plate 220, and/or the rear plate 280. In an embodiment, "the front or rear of the housing 201" may refer to the first surface 110A in FIG. 2 or the second surface 110B in FIG. 3. In an embodiment, the first support member 211 may be disposed between the front plate 220 (e.g., the first surface 110A in FIG. 2) and the rear plate 280 (e.g., the second surface 110B in FIG. 3) and may function as a structure for disposing electrical/electronic components such as the printed circuit board 240 or the camera assembly 207.

According to an embodiment, the display 230 may include a display panel 231 and a flexible printed circuit board 233 extending from the display panel 231. The flexible printed circuit board 233 may be understood as being disposed, for example, at least partially on the rear surface of the display panel 231 while being electrically connected to the display panel 231. In an embodiment, the reference number '231' may be understood as a protective sheet disposed on the rear surface of the display panel. For example, unless otherwise distinguished in the following detailed description, the protective sheet may be understood as a part of the display panel 231. In an embodiment, the protective sheet may function as an impact absorbing structure (e.g., a low-density elastic body such as a sponge) or an electromagnetic shielding structure (e.g., a copper sheet (CU sheet)). According to an embodiment, the display 230 may be disposed on an inner surface of the front plate 220, and by including a light-emitting layer, a screen may be output through the first surface 110A in FIG. 2 or at least a portion of the front plate 220. As mentioned earlier, the display 230 may output a screen through substantially the entire area of the first surface 110A in FIG. 2 or the front plate 220.

According to an embodiment, the memory may include, for example, a volatile memory or a non-volatile memory.

According to an embodiment, the interface may include, for example, an HDMI (high definition multimedia interface), a USB (universal serial bus) interface, an SD card interface, and/or an audio interface. The interface may, for example, electrically or physically connect the electronic device 101 to an external electronic device, and may include a USB connector, an SD card/MMC connector, or an audio connector.

According to an embodiment, the second support member 260 may include, for example, an upper support member 260a and a lower support member 260b. In an embodiment, the upper support member 260a may be disposed to enclose the printed circuit board 240 together with a portion of the first support member 211. Circuit devices implemented in the form of integrated circuit chips (e.g., a processor, a communication module, or a memory) and various electrical/electronic components may be disposed on the printed circuit board 240, and according to an embodiment, the printed circuit board 240 may be provided with an electromagnetic shielding environment from the upper support member 260a. In an embodiment, the lower support member 260b may be utilized as a structure capable of disposing electrical/electronic components such as a speaker module or an interface (e.g., a USB connector, an SD card/MMC connector, or an audio connector). In an embodiment, electrical/electronic components such as a speaker module or an interface (e.g., a USB connector, an SD card/MMC connector, or an audio connector) may be disposed on an additional printed circuit board (not illustrated). In this case, the lower support member 260b may be disposed to enclose the additional printed circuit board together with another portion of the first support member 211. A speaker module or an interface disposed on an additional printed circuit board (not illustrated) or the lower support member 260b may be disposed to correspond to the audio module (e.g., the microphone hole 103 or a speaker hole (e.g., the external speaker hole 107 or the call receiver hole 114)) or a connector hole (e.g., the first connector hole 109A or the second connector hole 109B) in FIG. 2.

According to an embodiment, the audio module 207 or the connector hole 108, 109 may be disposed to correspond.

According to an embodiment, the battery 250 is a device for supplying power to at least one component of the electronic device 101, and may include, for example, a non-rechargeable primary battery, a rechargeable secondary battery, or a fuel cell. At least a portion of the battery 250 may be disposed, for example, on substantially the same plane as the printed circuit board 240. The battery 250 may be disposed integrally inside the electronic device 101, or may be disposed in a removable manner with the electronic device 101.

According to an embodiment, the electronic device 101 may further include a separate sub-circuit board 290 spaced apart from the printed circuit board 240 within the first support member 211. The sub-circuit board 290 may be electrically connected to the printed circuit board 240 through a connection member such as a connection flexible substrate or a cable. The sub-circuit board 290 may be electrically connected to electrical components disposed in an end region of the electronic device 101, such as the battery 250 or a speaker, a USB connector, an antenna connector, and/or a SIM socket, and may transmit signals and power.

Although not illustrated, the antenna may include, for example, a conductor pattern implemented on the surface of the second support member 260 through a laser direct structuring method. In an embodiment, the antenna may include a printed circuit pattern formed on a surface of a thin film, and the antenna in the form of a thin film may be disposed between the rear plate 280 and the battery 250. The antenna may include, for example, an NFC (near field communication) antenna, a wireless charging antenna, and/or an MST (magnetic secure transmission) antenna. The antenna may, for example, perform short-range communication with an external device or wirelessly transmit and receive power required for charging. In an embodiment, a different antenna structure may be formed by the side structure 210 and/or a portion of the first support member 211 or a combination thereof.

According to an embodiment, the camera assembly 207 may include at least one camera module. Inside the electronic device 101, the camera assembly 207 may receive at least a portion of light incident through an optical hole or camera windows 212, 213, 219. In an embodiment, the camera assembly 207 may be disposed on the first support member 211 at a location adjacent to the printed circuit board 240. In an embodiment, the camera module(s) of the camera assembly 207 may be generally aligned with any one of the camera windows 212, 213, 219, and may be at least partially enclosed by the second support member 260 (e.g., the upper support member 260a).

Hereinafter, the structure of the display 230 is described in detail.

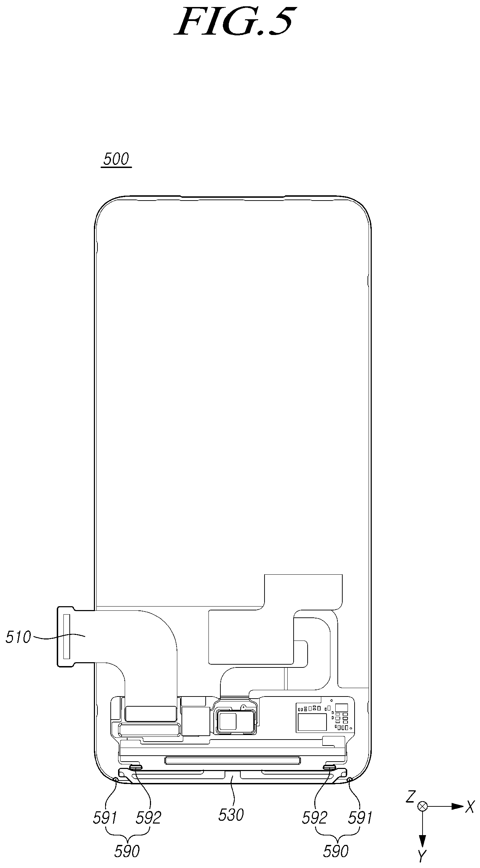

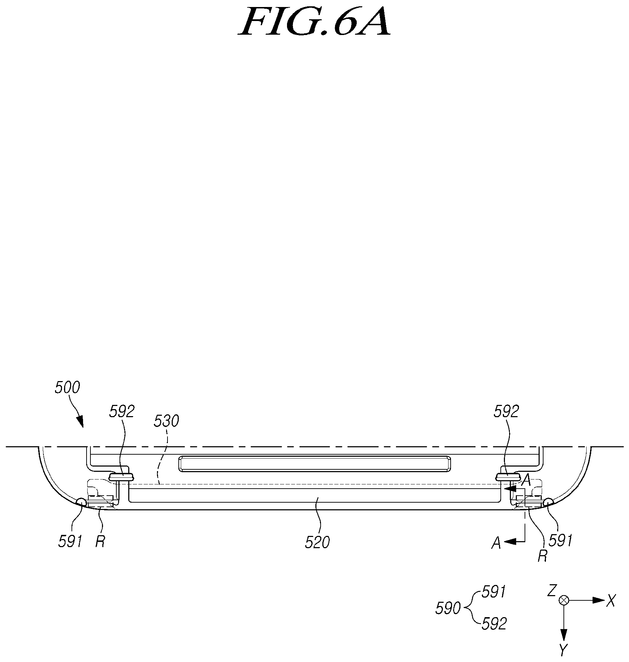

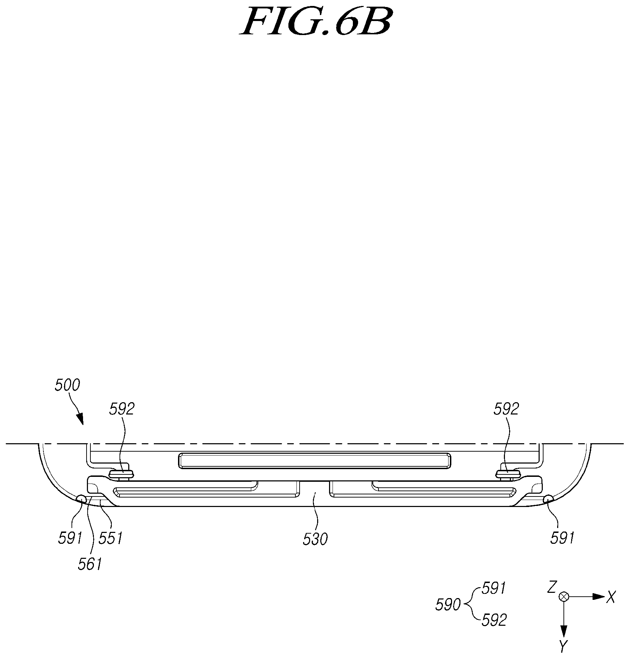

FIG. 5 is a rear view of a display assembly according to an embodiment. FIG. 6A is an enlarged view of a portion of FIG. 5 according to an embodiment, a view in a state where the resin layer is omitted. FIG. 6B is an enlarged view of a portion of FIG. 5 according to an embodiment.

All features, components, and/or arrangement relationships between components shown in FIGS. 5, 6A, and 6B may be included, individually or in combination, in the features, components, and arrangement relationships between components described in other drawings of the present specification. Similarly, all features, components, and/or arrangement relationships between components described in connection with FIGS. 1 to 4B and FIGS. 7 to 14 may be included, individually or in combination, in the features, components, and arrangement relationships between components described in FIGS. 5, 6A, and 6B.

The display assembly 500 shown in FIGS. 5 to 6B may be substantially the same or similar to the display (e.g., the display 230 in FIG. 4A) shown in FIGS. 4A and 4B. The display assembly 500 in FIGS. 5 to 6B may be included in the electronic device (e.g., the electronic device 101 in FIG. 2) in FIGS. 2 to 4B.

Referring to FIGS. 5 to 6B, the display assembly 500 may include at least one of a connector 510, a flexible circuit board 520, or a resin layer 530.

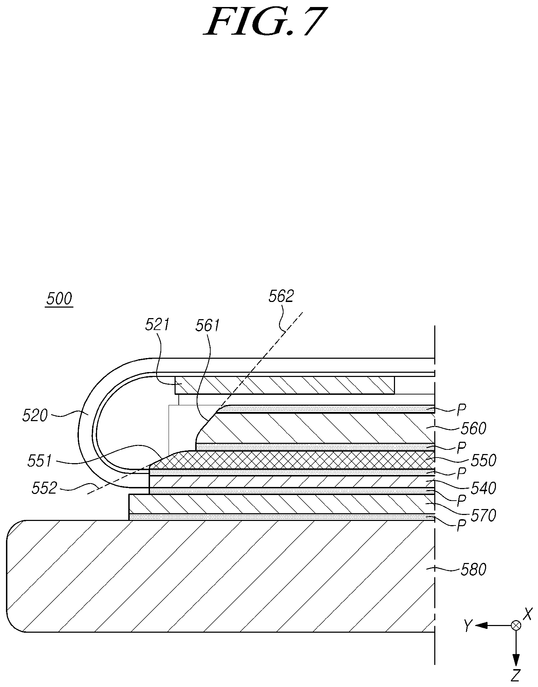

According to an embodiment, the connector 510 may be connected to an external power source. For example, the connector 510 may be electrically connected to a battery (e.g., the battery 250 of FIG. 4A). Power transmitted through the connector 510 may be supplied to various electronic components such as a display driving chip (e.g., the display driving chip 521 of FIG. 7) of a printed circuit board and the flexible circuit board 520.

According to an embodiment, a portion of the flexible circuit board 520 may extend from the display panel (e.g., the display panel 540 of FIG. 7). The flexible circuit board 520 may be disposed such that it extends from the display panel 540 and folds back to at least a portion of a rear surface of the display assembly 500. A portion of the flexible circuit board 520 extending from the display panel 540 may be formed in a bent manner. The flexible circuit board 520 may be electrically connected to the display panel 540. A portion of the flexible circuit board 520 may extend outwardly from an edge of the display panel 540. The flexible circuit board 520 may include a display driver IC (DDI) or a touch display driver IC (TDDI). The flexible circuit board 520 may have a COF (chip on film) or COP (chip on panel or chip on plastic) structure with a DDI or TDDI disposed on one surface thereof.

According to an embodiment, various components related to driving of the display panel 540 may be disposed on the flexible circuit board 520. For example, a display flash memory, an ESD prevention diode, a pressure sensor, and/or passive components may be disposed on the flexible circuit board 520.

According to an embodiment, the resin layer 530 may be disposed so as to surround at least a portion of the flexible circuit board 520. The resin layer 530 may be disposed so as to surround the flexible circuit board 520 folded on the outside of the display panel 540. When the display assembly 500 mounted in the electronic device 101 is subjected to an external impact, the resin layer 530 may protect the flexible circuit board 520, which is a vulnerable part prone to damage.

As the resin layer 530 protects the flexible circuit board 520, damage to the flexible circuit board 520 caused by the flexible circuit board 520 contacting or colliding with the housing 110 of the electronic device 101 may be reduced or decreased. Additionally, as the resin layer 530 serves to strongly fix the flexible circuit board 520, a size of a safety space provided as a free space inside the electronic device 101 for protection of the flexible circuit board 520 may be reduced, to make it possible to secure more space within the electronic device 101 for accommodating electronic components.

According to an embodiment, the resin layer 530 may be formed to extend along an edge of the display assembly 500.

According to an embodiment, the resin layer 530 may be formed in such a manner that molding liquid is filled around the flexible circuit board 520 using a jig device. A detailed description thereof will be provided below.

According to an embodiment, the display assembly 500 may further include a sealing member 590. The sealing member 590 may be disposed to block molding liquid from leaking to the surroundings during a process of injecting molding liquid for forming the resin layer 530. The position of the sealing member 590 is not limited to what is illustrated, and it may be disposed anywhere in a stepped space around the resin layer 530 where molding liquid leakage is likely to occur, depending on the shape of the display assembly 500.

According to an embodiment, the sealing member 590 may include a first sealing member 591 and a second sealing member 592. The first sealing member 591 may be disposed near the first inclined surface 551 or the second inclined surface 561 to reduce molding liquid from leaking along the edge of the display assembly 500. The first sealing member 591 may be disposed, for example, to reduce molding liquid from leaking between a step formed by the metal layer 560 and the polymer layer 550 or between a step formed by the polymer layer 550 and the display panel 540. The second sealing member 592 may be disposed at a stepped portion formed by a configuration such as a printed circuit board in the vicinity of the resin layer 530 to reduce molding liquid from leaking in a direction inward within the plane of the display assembly 500.

FIG. 7 is a side cross-sectional view taken along the line A-A of FIG. 6A according to an embodiment.

All features, components, and/or arrangement relationships between components illustrated in FIG. 7 may be included, alone or in combination, with features, components, and arrangement relationships between components described in other drawings of the present specification. Similarly, all features, components, and/or arrangement relationships between components described with reference to FIGS. 1 to 6B, and FIGS. 8 to 14 may be included, alone or in combination, with features, components, and arrangement relationships between components described in FIG. 7.

Referring to FIG. 7, the display assembly 500 may include at least one of a display panel 540, a polymer layer 550, a metal layer 560, a polarizing layer 570, or a protective layer 580. However, this is exemplary, and other layers may be added or existing layers may be omitted.

According to an embodiment, the display panel 540 may include a plurality of pixels and a wiring structure (e.g., electrode patterns). According to an embodiment, the display panel 540 may include a touch panel (not illustrated). The display panel 540 may be, for example, a deformable or bendable flexible display.

According to an embodiment, the polymer layer 550 may be disposed on a rear surface of the display panel 540. The polymer layer 550 may be adhered or attached to the display panel 540 by an adhesive member P. The polymer layer 550 may provide a dark background to ensure visibility of the display panel 540. The polymer layer 550 may be formed of a cushioning material that serves a buffering function to protect the display panel 540. According to an embodiment, the polymer layer 550 may be omitted for waterproofing of the display panel 540, or may be disposed on a rear surface of the metal layer 560.

According to an embodiment, the polymer layer 550 may include a plastic film as a base layer. The polymer layer 550 may include a plastic film including any one selected from the group consisting of polyethersulphone (PES), polyacrylate (PAR), polyetherimide (PEI), polyethylene naphthalate (PEN), polyethylene terephthalate (PET), polyphenylene sulphide (PPS), polyarylate, polyimide (PI), polycarbonate (PC), or combinations thereof.

The material constituting the polymer layer 550 is not limited to plastic resins and may include organic/inorganic composite materials. The polymer layer 550 may include a porous organic layer and an inorganic material filled in the pores of the organic layer.

According to an embodiment, the metal layer 560 may be disposed on a rear surface of the polymer layer 550. The metal layer 560 may be disposed to mitigate an impact applied from behind the display panel 540. The metal layer 560 may be disposed to dissipate or release heat from inside the electronic device 101. The metal layer 560 may be adhered or attached to the polymer layer 550 by an adhesive member P. The metal layer 560 may include at least one of stainless steel (STS), Cu, Al, or metal CLAD. However, it is not limited thereto, and the metal layer 560 may include other alloy materials. For example, the metal layer 560 may help strengthen the rigidity of the display assembly 500, shield surrounding noise, and be used to dissipate heat emitted from surrounding heat-emitting components.

According to an embodiment, the metal layer 560 may help strengthen the rigidity of the electronic device. According to an embodiment, the metal layer 560 may shield surrounding noise and be used to dissipate heat emitted from surrounding heat-emitting components. The metal layer 560 may include at least one of stainless steel (STS), Cu, Al, or other alloy materials. The metal layer 560 may be omitted in some form factors of the electronic device.

According to an embodiment, the display assembly 500 may include a digitizer panel (not illustrated) disposed on a rear surface of the metal layer 560 and configured to sense an input of an electronic pen (e.g., a stylus pen).

According to various embodiments, the display assembly 500 may include other types of functional members in addition to the illustrated configuration. For example, the display assembly 500 may include at least one functional member disposed between the polymer layer 550 and the metal layer 560, or on a rear surface of the metal layer 560. According to an embodiment, the functional member may include at least one of a graphite sheet for heat dissipation, a touch sensor supporting a touch function of the display assembly 500, a fingerprint sensor FPCB, a communication antenna radiator, or a conductive/non-conductive tape.

According to an embodiment, a polarizing layer 570 (POL, polarizer) (e.g., a polarizing film) may be disposed on an upper surface of the display panel 540. The polarizing layer 570 may be adhered or attached to the display panel 540 by an adhesive member P. The polarizing layer 570 may selectively transmit light generated from a light source of the display panel 540 and oscillating in a specific direction. According to an embodiment, the polarizing layer 570 may be integrally formed with the display panel 540.

According to an embodiment, the protective layer 580 may be disposed on a front surface of the polarizing layer 570. The protective layer 580 may be adhered or attached to the polarizing layer 570 by an adhesive member P. The protective layer 580 may be referred to as a window layer. The protective layer 580 may include, for example, ultra-thin glass (UTG). The protective layer 580 may include, for example, a polymer. The protective layer 580 may include, for example, polyethylene terephthalate (PET) or polyimide (PI). The protective layer 580 may comprise, for example, a plurality of layers including a glass layer and a polymer.

According to an embodiment, the display assembly 500 may include an adhesive member P. The adhesive member P may include, for example, at least one of an optical clear adhesive (OCA), a pressure sensitive adhesive (PSA), a thermosetting adhesive, a general adhesive, or a double-sided tape.

According to an embodiment, the display assembly 500 may be formed such that at least a portion of an edge thereof is inclined. For example, the display assembly 500 may be etched such that a portion of the edge is inclined.

According to an embodiment, the polymer layer 550 may include a first inclined surface 551 formed such that at least a portion of the edge thereof is inclined outward from a plane of the polymer layer 550 along a direction toward the display panel 540. The first inclined surface 551 may be formed such that at least a portion of the edge of the polymer layer 550 forms a substantially obtuse angle with respect to a rear surface of the display panel 540. The first inclined surface 551 may be a planar or curved surface. For example, the first inclined surface 551 may have a shape of a curved surface that is convex outwardly. For example, the first inclined surface 551 may be formed such that a slope decreases as distance from the display panel 540 increases. An area of the polymer layer 550 may be smaller than an area of the display panel 540. An edge of the display panel 540 may be disposed to protrude outwardly with respect to the polymer layer 550.

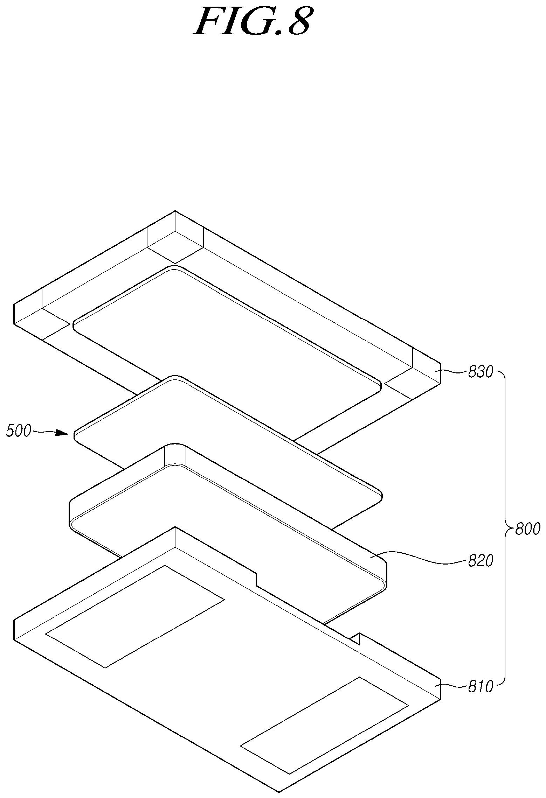

The first inclined surface 551 may reduce molding liquid from leaking when molding liquid is injected into an area around the flexible circuit board 520 of the display assembly 500 accommodated in a jig device for forming the resin layer 530. The first inclined surface 551 may reduce molding liquid from leaking by bringing the display assembly 500 into close contact with a molding cap (e.g., the molding cap 820 of FIG. 8). A detailed description will be provided below.

According to an embodiment, as illustrated, an edge of the adhesive member P corresponding to the first inclined surface 551 may also have a shape inclined to face an outward direction as it goes toward the display panel 540 direction. According to an embodiment, during a process of etching to form the first inclined surface 551 on a portion of the edge of the polymer layer 550, the adhesive member P applied on the front and/or rear surface of the polymer layer 550 may also be etched together.

According to an embodiment, the metal layer 560 may be disposed on a rear surface of the polymer layer 550 and formed such that an edge thereof is stepped inwardly with respect to the polymer layer 550. An area of the metal layer 560 may be smaller than an area of the polymer layer 550. An edge of the polymer layer 550 may be disposed to protrude outwardly with respect to the metal layer 560.

According to an embodiment, the metal layer 560 may include a second inclined surface 561 formed such that at least a portion of the edge is inclined outward from a plane of the metal layer 560 along a direction toward the polymer layer 550. The second inclined surface 561 may be formed such that at least a portion of the edge of the metal layer 560 forms a substantially obtuse angle with respect to a rear surface of the polymer layer 550. The second inclined surface 561 may be formed, for example, to be inclined outward from the plane of the metal layer 560 in the direction toward the display panel 540. The second inclined surface 561 may be a planar or curved surface. For example, the second inclined surface 561 may have a shape of a curved surface that is convex outwardly. For example, the second inclined surface 561 may be formed such that a slope decreases as distance from the polymer layer 550 (or the display panel 540) increases.

According to an embodiment, the second inclined surface 561 may be disposed at a length direction end of the resin layer 530. A portion of the second inclined surface 561 may be positioned to overlap the resin layer 530. A portion of the second inclined surface 561 may be formed in a region within a predetermined distance from the longitudinal end of the resin layer 530. For example, the second inclined surface may be formed in the R region shown in FIG. 6A. The second inclined surface 561 may reduce leakage of molding compound when molding compound is injected around the area of the flexible circuit board 520 in the display assembly 500 accommodated in the jig device for forming the resin layer 530. The second inclined surface 561 may reduce leakage of molding compound by bringing the display assembly 500 into close contact with a molding cap (e.g., the molding cap 820 shown in FIG. 8). Detailed descriptions are provided hereinafter.

According to an embodiment, the edge of the adhesive member P corresponding to the second inclined surface 561 also has, as illustrated, a shape inclined toward an outward direction as it extends toward the direction of the polymer layer 550 or the direction if the display panel 540. According to an embodiment, in the process of etching to form the second inclined surface 561 on a portion of the edge of the metal layer 560, the adhesive member P applied to the front surface and/or rear surface of the metal layer 560 may also be etched together.

According to an embodiment, the second inclined surface 561 may be positioned to correspond to the first inclined surface 551. The second inclined surface 561 may be positioned behind the first inclined surface 551.

According to an embodiment, the average slope 562 of the second inclined surface 561 may be greater than the average slope 552 of the first inclined surface 551. Here, the average slope 562 of the second inclined surface 561 may refer to the slope of a straight line connecting a lower point of the second inclined surface 561 and an upper point of the second inclined surface 561. Here, the average slope 552 of the first inclined surface 551 may refer to the slope of a straight line connecting a lower point of the first inclined surface 551 and an upper point of the first inclined surface 551.

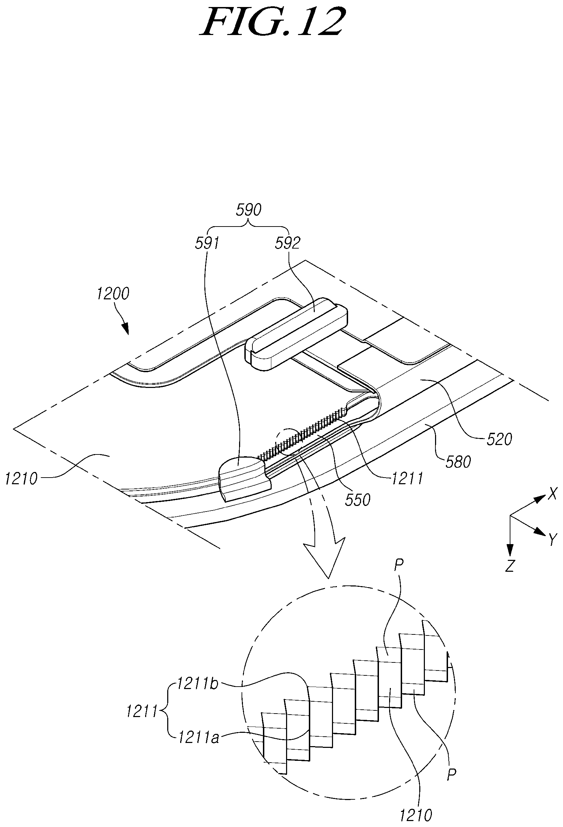

According to an embodiment, unlike as illustrated, the second inclined surface 561 may have a concavo-convex shape facing an outward direction of the metal layer 560. For example, the second inclined surface 561 may have a pattern shape with protrusions and recesses alternately arranged along the edge of the metal layer 560. The concavo-convex shape may be the same as or similar to the shape illustrated in FIG. 12. In other words, the second inclined surface 561 may have a concavo-convex shape on the inclined surface.

Referring to FIGS. 6A, 6B, and 7, the first inclined surface 551 may be disposed at a length direction end of the resin layer 530. A portion of the first inclined surface 551 may be positioned to overlap the resin layer 530. A portion of the first inclined surface 551 may be formed in a region within a predetermined distance from the longitudinal end of the resin layer 530. For example, the first inclined surface may be formed in the R region shown in FIG. 6A.

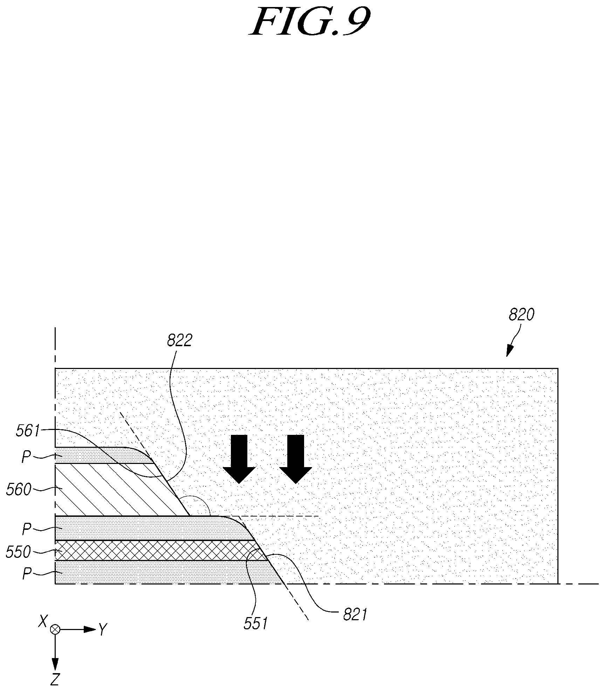

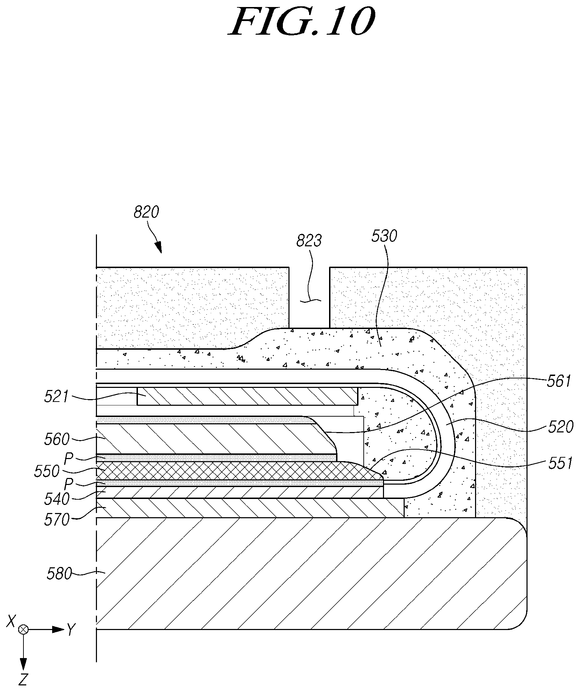

FIG. 8 is an exploded perspective view of a jig device prepared for filling a resin layer in the display assembly according to an embodiment. FIG. 9 is a schematic view for illustrating a coupling relationship between the display assembly and the molding cap according to an embodiment. FIG. 10 is a schematic view for explaining a process of filling molding compound using the jig device of FIG. 8 according to an embodiment.

All features, components, and/or arrangement relationships between components illustrated in FIGS. 8 through 10 may be included, alone or in combination, in the features, components, and arrangement relationships between components described in other drawings in this specification. Similarly, all features, components, and/or arrangement relationships between components described in relation to FIGS. 1 through 7 and FIGS. 11 through 14 may be included, alone or in combination, in the features, components, and arrangement relationships between components described in FIGS. 8 through 10.

Referring to FIGS. 8 through 10, the jig device 800 for filling the resin layer 530 in the display assembly 500 may include a base jig 810, a molding cap 820, and an upper jig 830. The molding cap 820 may be made of silicone material, but is not limited thereto.

As shown in FIG. 6A, the display assembly 500 in a state before the resin layer 530 is formed may be seated or fitted into the molding cap 820. When the display assembly 500 is fitted into the molding cap 820, the fitting force or close contact force between the molding cap 820 and the display assembly 500 is enhanced by the first inclined surface 551 and the second inclined surface 561, and leakage of molding compound may be minimized.

FIG. 9 is a cross-sectional view of a portion where the molding cap 820 contacts the inclined surfaces (the first inclined surface 551 and the second inclined surface 561) of the display assembly 500. As illustrated in FIG. 9, the molding cap 820 may include a third inclined surface 821 facing the first inclined surface 551 and a fourth inclined surface 822 facing the second inclined surface 561. As the molding cap 820 applies a force in the downward direction in the drawing, the third inclined surface 821 may be brought into close contact with the first inclined surface 551, and the fourth inclined surface 822 may be brought into close contact with the second inclined surface 561. For example, the first inclined surface 551 and the second inclined surface 561 may be more efficiently brought into close contact with each other by being pressed by the third inclined surface 821 and the fourth inclined surface 822 due to the curved shape of the first inclined surface 551 and the second inclined surface 561 that is convex in the outward direction. Due to the structure of the first inclined surface 551 and the second inclined surface 561 of the display assembly 500, leakage of molding compound may be minimized during filling of molding compound. In other words, the first inclined surface 551 and the second inclined surface 561 may enhance the fitting force or close contact force with the molding cap 820, and may reduce the amount of molding compound leakage during filling of molding compound.

When the display assembly 500 is seated or fitted into the molding cap 820, force is applied in the downward direction in FIG. 9 by the molding cap 820, but in a case where the edge is a vertical surface that has not been etched, like in the conventional display assembly 500, sufficient close contact may not be achieved between the molding cap 820 and the display assembly 500 despite the force applied in the downward direction of the molding cap 820. As a result, a gap may be created and molding compound may leak out. In the disclosure, by forming an inclined surface on a portion of the edge of the display assembly 500, the fitting force or close contact force between the molding cap 820 and the display assembly 500 may be enhanced.

After seating or fitting the display assembly 500 into the molding cap 820, the molding cap 820 may be disposed on the base jig 810. An upper jig 830 may be coupled to the upper portion of the base jig 810. By coupling the base jig 810 and the upper jig 830, the position of the molding cap 820 may be fixed.

After fixing the molding cap 820, molding compound may be injected into the injection port 823 of the molding cap 820 as illustrated in FIG. 10. The molding compound may be an epoxy molding compound, but is not limited thereto. The spreading of a portion of the injected molding compound that leaks may be blocked by the sealing member 590.

The molding compound injected through the injection port 823 of the molding cap 820 may be filled not only on the outer side but also on the inner side of the flexible circuit board 520. In other words, molding compound may be filled such that it surrounds the inner surface and outer surface of the flexible circuit board 520.

After the injection of molding compound is completed, the molding compound may be cured as the resin layer 530 by undergoing a heat curing process while removing air bubbles inside the molding compound.

After completing the heat curing process, the assembled molding cap 820 may be separated by cooling the base jig 810 and the upper jig 830.

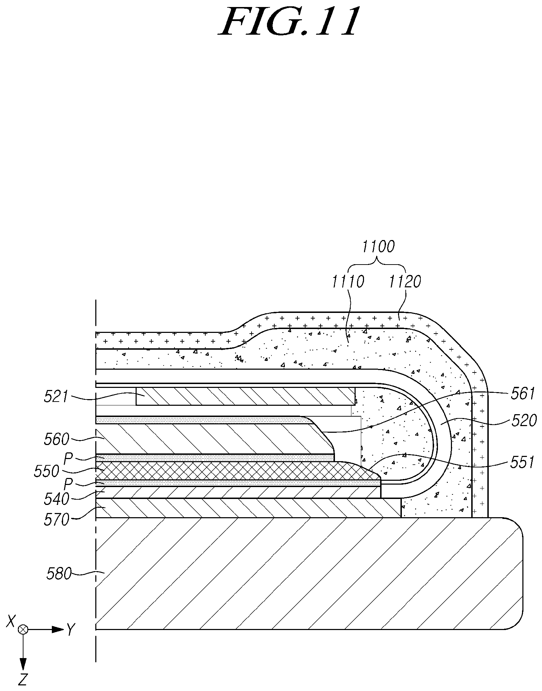

FIG. 11 is a schematic view showing two types of resin layers having different hardness according to an embodiment.

All features, components, and/or arrangement relationships between components illustrated in FIG. 11 may be included, alone or in combination, in the features, components, and arrangement relationships between components described in other drawings in this specification. Similarly, all features, components, and/or arrangement relationships between components described in relation to FIGS. 1 through 10 and FIGS. 12 through 14 may be included, alone or in combination, in the features, components, and arrangement relationships between components described in FIG. 11.

The resin layer 1100 illustrated in FIG. 11 may be an alternative embodiment of the resin layer (e.g., the resin layer 530 of FIG. 5). The resin layer 1100 illustrated in FIG. 11 may be included in the display assembly (e.g., the display assembly 500 of FIG. 5) of FIG. 5 as a replacement for the resin layer 530 of FIG. 5. In FIG. 11, the same reference denotations are used for components that are substantially the same as or similar to the components described above, other than the resin layer 1100.

According to an embodiment, the resin layer 1100 may include a first resin layer 1110 and a second resin layer 1120. Through the injection port 823 of the molding cap 820, after injecting and curing the first molding compound for forming the first resin layer 1110, the resin layer 1100 may be formed by injecting and curing the second molding compound for forming the second resin layer 1120 to fill the remaining portion. The second resin layer 1120 may be disposed outer than the first resin layer 1110. The first resin layer 1110 and the second resin layer 1120 may be integrally formed.

According to an embodiment, the first resin layer 1110 may have lower hardness than the second resin layer 1120. By filling the first molding compound having relatively lower hardness, molding compound may be filled in the gap space between the flexible circuit boards 520. Further, by filling the second molding compound having relatively higher hardness on the surface, impact resistance performance may be enhanced.

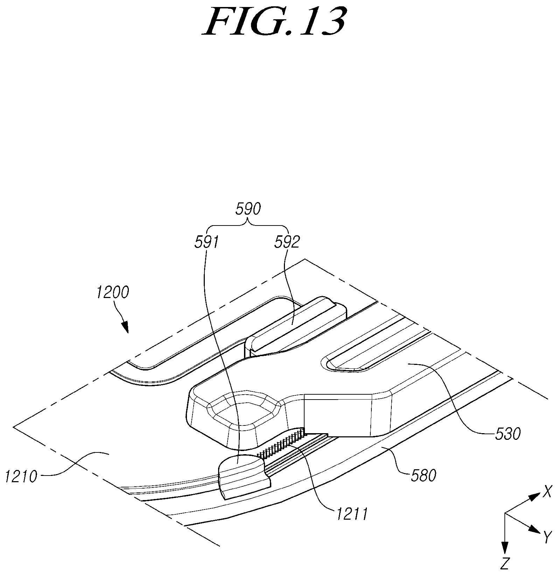

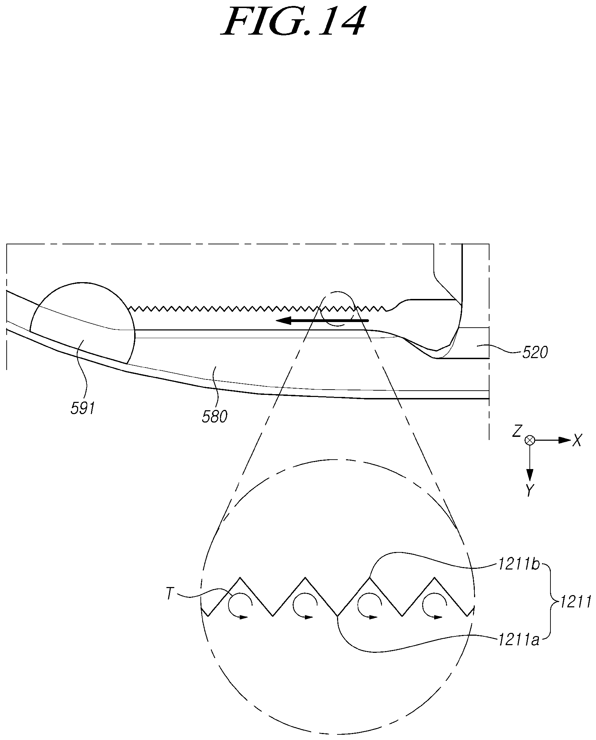

FIG. 12 is a view of a partial perspective view of the display assembly according to an embodiment with the resin layer omitted. FIG. 13 is a partial perspective view of the display assembly according to an embodiment. FIG. 14 is an enlarged rear view of a portion of the display assembly according to an embodiment.

All features, components, and/or arrangement relationships between components illustrated in FIGS. 12 through 14 may be included, alone or in combination, in the features, components, and arrangement relationships between components described in other drawings in this specification. Similarly, all features, components, and/or arrangement relationships between components described in relation to FIGS. 1 through 11 may be included, alone or in combination, in the features, components, and arrangement relationships between components described in FIGS. 12 through 14.

Among the components of the display assembly 1200 illustrated in FIGS. 12 through 14, the same reference denotations are used for components that are substantially the same as or similar to those described in relation to the display assembly 500 in FIGS. 5 through 10.

Referring to FIGS. 12 through 14, the display assembly 1200 may have a concavo-convex structure formed on a portion of the edge.

According to an embodiment, at least a portion of the edge of the metal layer 1210 may have a concavo-convex structure 1211 (or concavo-convex shape) facing an outward direction of the metal layer 1210. For example, the metal layer 1210 may have a pattern shape with convex portions 1211a and concave portions 1211b alternately arranged along the edge. Here, the region of the edge of the metal layer 1210 having the concavo-convex structure 1211 or the alternately arranged pattern shape of the convex portions 1211a and concave portions 1211b may be referred to as a "concavo-convex region".

According to an embodiment, a portion of the concavo-convex region may be positioned to overlap the longitudinal end of the resin layer 530. The concavo-convex region may be formed in a region within a predetermined distance from the longitudinal direction end of the resin layer 530. The concavo-convex region may correspond to, for example, the R region in FIG. 6A.

According to an embodiment, the adhesive member applied to the front surface and/or rear surface of the metal layer 1210 may also be etched together with the metal layer 1210 and may have a concavo-convex shape.

In the display assembly 1200, leakage of molding compound may be reduced by forming a concavo-convex structure around the edge of the resin layer 530. When molding compound leaks through the stepped space formed between the metal layer 1210 and the polymer layer 550, the molding compound may form eddy T in the concave portion 1211b of the concavo-convex structure 1211, and may suppress leakage of molding compound along the edge.

According to an embodiment of the disclosure, a display assembly 500 may include a display panel 540, a polymer layer 550 disposed on a rear surface of the display panel 540, a flexible circuit board 520 electrically connected to the display panel 540 with a portion disposed outside an edge of the display panel 540, a display driving chip 521 mounted on the flexible circuit board 520, and a resin layer 530 configured to surround the flexible circuit board 520. The polymer layer 550 may include a first inclined surface 551 that is a planar or curved, with at least a portion of its edge forming a substantially obtuse angle with respect to the rear surface of the display panel 540.

According to an embodiment, the first inclined surface 551 may be formed such that a slope decreases as the distance from the display panel 540 increases.

According to an embodiment, the display assembly 500 may further include a metal layer 560 disposed on a rear surface of the polymer layer 550 and having an edge stepped inwardly with respect to the polymer layer 550. The metal layer 560 may include a second inclined surface 561 that is a planar or curved surface wherein at least a portion of its edge forms a substantially obtuse angle with respect to the rear surface of the polymer layer 550.

According to an embodiment, an average slope of the second inclined surface 561 may be greater than an average slope of the first inclined surface 551.

According to an embodiment, the second inclined surface 561 may have a concavo-convex shape facing an outward direction of the metal layer 560.

According to an embodiment, the second inclined surface 561 may have a pattern shape in which protrusions and recesses are alternately arranged along an edge of the metal layer 560.

According to an embodiment, the second inclined surface 561 may be positioned to correspond to the first inclined surface 551.

According to an embodiment, a portion of the first inclined surface 551 may be positioned to overlap a longitudinal direction end of the resin layer 530.

According to an embodiment, the display assembly 500 may further include a metal layer 560 disposed on a rear surface of the polymer layer 550, of which edge stepped inwardly with respect to the polymer layer 550. The metal layer 560 may have at least a portion of an edge with a concavo-convex shape facing an outward direction of the metal layer 560.

According to an embodiment, the first inclined surface 551 may be formed in an area within a predetermined distance from a longitudinal direction end of the resin layer 530.

According to an embodiment, the resin layer 530 may include a first resin layer surrounding the flexible circuit board 520 and a second resin layer surrounding at least a portion of the first resin layer and having a hardness greater than the first resin layer.

According to an embodiment, the display assembly 500 may further include a sealing member 590 disposed to block leakage of a molding liquid in at least a portion of a periphery of the resin layer 530.

According to an embodiment of the disclosure, an electronic device 101 may comprise a housing 110 and a display assembly 500 disposed on the housing. The display assembly 500 may comprise a display panel 540, a polymer layer 550 disposed on a rear surface of the display panel 540, a flexible circuit board 520 electrically connected to the display panel 540 with a portion disposed outside an edge of the display panel 540, a display driving chip 521 mounted on the flexible circuit board 520, and a resin layer 530 configured to surround the flexible circuit board 520. The polymer layer 550 may comprise a first inclined surface 551 that is a planar or curved surface wherein at least a portion of an edge forms a substantially obtuse angle with respect to the rear surface of the display panel 540.

According to an embodiment, the first inclined surface 551 may be formed such that a slope decreases toward an upper portion.

According to an embodiment, the display assembly 500 may further comprise a metal layer 560 disposed on a rear surface of the polymer layer 550, of which edge stepped inwardly with respect to the polymer layer 550. The metal layer 560 may comprise a second inclined surface 561 that is a planar or curved surface formed such that at least a portion of the edge is inclined in an outward from a plane of the metal layer 560 along a direction toward the polymer layer 550.

According to an embodiment, an average slope of the second inclined surface 561 may be greater than an average slope of the first inclined surface 551.

According to an embodiment, the second inclined surface 561 may have a concavo-convex shape facing an outward direction of the metal layer 560.

According to an embodiment, the second inclined surface 561 may be positioned to correspond to the first inclined surface 551.

According to an embodiment, a portion of the first inclined surface 551 may be positioned to overlap a longitudinal direction end of the resin layer 530.

According to an embodiment, the display assembly 500 may further comprise a metal layer 560 disposed on a rear surface of the polymer layer 550 and having an edge stepped inwardly with respect to the polymer layer 550. The metal layer 560 may have at least a portion of an edge with a concavo-convex shape facing an outward direction of the metal layer 560.

According to an embodiment, the first inclined surface 551 may be formed in an area within a predetermined distance from a longitudinal direction end of the resin layer 530.

According to an embodiment, the resin layer 530 may comprise a first resin layer 530 surrounding the flexible circuit board 520 and a second resin layer 530 surrounding at least a portion of the first resin layer 530 and having a hardness greater than the first resin layer 530.

According to an embodiment, the display assembly 500 may further include a sealing member 590 disposed to block leakage of a molding liquid in at least a portion of a periphery of the resin layer 530.

Various embodiments of the disclosure may include a resin layer that protects a flexible circuit board extending from a display panel from external impact.

Various embodiments of the disclosure may reduce leakage of a molding liquid to surrounding components during filling with molding liquid.

According to various embodiments proposed in the disclosure, a display assembly may protect a flexible circuit board extending from a display panel from external impact by adding a resin layer surrounding the flexible circuit board.

According to various embodiments proposed in the disclosure, a display assembly may reduce leakage of molding liquid during filling with molding liquid for forming a resin layer, to reduce a defect occurrence rate.

Terms used in the disclosure are used to describe specific embodiments only and are not intended to limit the disclosure. For example, a component expressed in the singular form should be understood to include a plurality of components unless the context explicitly indicates otherwise. In the disclosure, phrases such as "A or B", "at least one of A and B", "at least one of A or B", "A, B or C", "at least one of A, B and C", and "at least one of A, B, or C" each means any one of the items listed together in the corresponding phrase, or any possible combination thereof. It should be understood that the term "and/or" as used in the disclosure encompasses all possible combinations of one or more of the listed items. Terms such as "include," "have," "consist of," etc. as used in the disclosure are intended to specify the existence of features, components, parts, or combinations thereof as described in the disclosure, and the use of these terms does not exclude the possibility of the existence or addition of one or more other features, components, parts, or combinations thereof. Expressions such as "first" and "second" as used in the disclosure may modify various components regardless of order and/or importance, and are used only to distinguish one component from another component and do not limit the components.

The term "configured to" as used in the disclosure may be, depending on the situation, for example, appropriately replaced with "suitable for," "having the ability to," "designed to," "changed to," "made to," or "capable of," etc. The term "configured to" may not necessarily mean hardware that is "specially designed". Instead, in some contexts, the expression "a device configured to" may mean that the device is capable of performing in conjunction with other devices or components. For example, the phrase "a device configured to perform A, B and C" may mean a dedicated device designed to perform the corresponding operation, or it may mean a general-purpose device capable of performing various operations including those corresponding operation.

Meanwhile, in the disclosure, terms such as "upper," "lower," and "front-to-back direction" are defined with reference to the drawings, and the shape and position of each component are not limited by these terms.

The foregoing descriptions of the disclosure have been made centering on specific embodiments; however, the disclosure is not limited to such specific embodiments, and it is to be understood that the disclosure covers all various changes, equivalents, and/or alternatives of the various embodiments.

## Claims

1. A display assembly comprising:
a display panel (540);
a polymer layer (550) disposed on a rear surface of the display panel (540);
a flexible circuit board (520) electrically connected to the display panel (540), a portion of which is disposed outside an edge of the display panel (540);
a display driving chip (521) mounted on the flexible circuit board (520); and
a resin layer (530) configured to surround the flexible circuit board (520),
wherein the polymer layer (550) comprises a first inclined surface (551) having a planar or curved shape, at least a portion of an edge of which forms a substantially obtuse angle with respect to the rear surface of the display panel (540).

2. The display assembly of claim 1, wherein the first inclined surface (551) is formed such that a slope thereof decreases as a distance from the display panel (540) increases.

3. The display assembly of claim 1 or 2, further comprising a metal layer (560) disposed on a rear surface of the polymer layer (550), an edge of which is stepped inward with respect to the polymer layer (550),
wherein the metal layer (560) comprises a second inclined surface (561) having a planar or curved shape, at least a portion of an edge of which forms a substantially obtuse angle with respect to the rear surface of the polymer layer (550), and
an average slope of the second inclined surface (561) is greater than an average slope of the first inclined surface (551).

4. The display assembly of claim 3, wherein the second inclined surface (561) has a concavo-convex shape facing an outward direction of the metal layer (560).

5. The display assembly of claim 3, wherein the second inclined surface (561) has a patterned shape in which protrusions and recesses are alternately arranged along an edge of the metal layer (560).

6. The display assembly of any one of claims 1 to 5, wherein the first inclined surface (551) is positioned such that a portion thereof overlaps a longitudinal end of the resin layer (530), and another portion thereof is formed in a region within a predetermined distance from the longitudinal end of the resin layer (530).

7. The display assembly of claim 1 or 2, further comprising a metal layer (560) disposed on a rear surface of the polymer layer (550), an edge of which is stepped inward with respect to the polymer layer (550),
wherein at least a portion of an edge of the metal layer (560) has a concavo-convex shape facing an outward direction of the metal layer (560).

8. The display assembly of any one of claims 1 to 7, wherein the resin layer (530) comprises a first resin layer surrounding the flexible circuit board (520), and a second resin layer surrounding at least a portion of the first resin layer and having a higher hardness than the first resin layer.

9. An electronic device comprising:
a housing; and
a display assembly (500) disposed on the housing,
wherein the display assembly (500) comprises:
a display panel (540);
a polymer layer (550) disposed on a rear surface of the display panel (540);
a flexible circuit board (520) electrically connected to the display panel (540), a portion of which is disposed outside an edge of the display panel (540);
a display driving chip (521) mounted on the flexible circuit board (520); and
a resin layer (530) configured to surround the flexible circuit board (520),
wherein the polymer layer (550) comprises a first inclined surface (551) in a planar or curved shape, at least a portion of an edge of which forms a substantially obtuse angle with respect to the rear surface of the display panel (540).

10. The electronic device of claim 9, wherein the first inclined surface (551) is formed such that a slope thereof decreases toward an upper side.

11. The electronic device of claim 9 or 10, wherein the display assembly (500) further comprises a metal layer (560) disposed on a rear surface of the polymer layer (550), an edge of which is stepped inward with respect to the polymer layer (550),
wherein the metal layer (560) comprises a second inclined surface (561) having a planar or curved shape, at least a portion of an edge of which is formed to be inclined outward from a plane of the metal layer (560) along a direction toward the polymer layer (550), and an average slope of the second inclined surface (561) is greater than an average slope of the first inclined surface (551).

12. The electronic device of claim 11, wherein the second inclined surface (561) has a concavo-convex shape facing an outward direction of the metal layer (560).

13. The electronic device of any one of claims 9 to 12, wherein the first inclined surface (551) is positioned such that a portion thereof overlaps a longitudinal end of the resin layer (530), and another portion thereof is formed in a region within a predetermined distance from the longitudinal end of the resin layer (530).

14. The electronic device of claim 9 or 10, wherein the display assembly (500) further comprises a metal layer (560) disposed on a rear surface of the polymer layer (550), an edge of which is stepped inward with respect to the polymer layer (550), wherein at least a portion of an edge of the metal layer (560) has a concavo-convex shape facing an outward direction of the metal layer (560).

15. The electronic device of any one of claims 9 to 14, wherein the resin layer (530) comprises a first resin layer (530) surrounding the flexible circuit board (520), and a second resin layer (530) surrounding at least a portion of the first resin layer (530) and having a higher hardness than the first resin layer (530).
